Europäisches Patentamt

European Patent Office

Office européen des brevets

(19)

(11) EP 1 122 612 A2

(12) **EUROPEAN PATENT APPLICATION**

(43) Date of publication:
08.08.2001 Bulletin 2001/32

(51) Int Cl.7: G03F 9/00

(21) Application number: 01300784.4

(22) Date of filing: 30.01.2001

(84) Designated Contracting States:
AT BE CH CY DE DK ES FI FR GB GR IE IT LI LU
MC NL PT SE TR
Designated Extension States:
AL LT LV MK RO SI

(30) Priority: 01.02.2000 JP 2000023437

(71) Applicant: Nikon Corporation
Tokyo 100-8331 (JP)

(72) Inventor: Yoshida, Kouji, c/o Nikon Corporation
Tokyo 100-8331 (JP)

(74) Representative: Gill, David Alan
W.P. Thompson & Co.,
Celcon House,
289-293 High Holborn
London WC1V 7HU (GB)

(54) **Position detection**

(57)    After the plural marks are picked-up by the image pick-up system AS under the image pick-up condition including the plural defocus states, the relationship between the picked-up image of the mark and the defocus amount is obtained. The relationship is the manner in the change of the picked-up image of the mark depending on the varied defocus amount. From the relationship between the obtained picked-up image of the mark and the defocus amount, the positional information of the mark is estimated. That is, the positional information of the mark is that should be obtained by using the image of the mark at the focus state. As a result, even when the contrast between the line pattern portion and the space pattern portion in the picked-up image of the mark at the focus state is low, the positional information of the mark is precisely detected.

Fig. 2A

EP 1 122 612 A2

**Description**

The present invention relates to a position detecting method, a position detecting apparatus, an exposure method, an exposure apparatus and a making method thereof, a computer readable recording medium, and a device manufacturing method. More particularly, the present invention relates to the position detecting method and the position detecting apparatus for detecting position information of marks formed on an object; the exposure method for using the position detecting method, the exposure apparatus comprising the position detecting apparatus and making method thereof; the computer readable recording medium in which the programs for controlling the position detecting method to be executed are stored; and the device manufacturing method for using the exposure method in a lithographic process.

DESCRIPTION OF THE RELATED ART

Conventionally, in the lithographic process for manufacturing a semiconductor device, liquid crystal display device and so forth, an exposure apparatus has been used. In such an exposure apparatus, patterns formed on a mask or reticle (to be genetically referred to as a "reticle" hereinafter) are transferred through a projection optical system onto a substrate such as a wafer or a glass plate (to be referred to as a "substrate or wafer" herein after, as needed) coated with a resist or the like. As the exposure apparatus, a static exposure type projection exposure apparatus such as a so-called stepper, or a scanning exposure type one such as a so-called scanning stepper is generally used.

In these exposure apparatus, prior to exposure, the positioning of the reticle and the wafer (alignment) must be precisely performed. In order to perform the alignment, position detection marks formed in the above-mentioned lithographic process, i.e., alignment marks formed by exposure transfer, are associated to each shot area. Therefore, the position of the wafer or the circuit pattern on the wafer might be detected by detecting the alignment mark. Then, the alignment is performed by using the detection result of the position of the wafer or the circuit pattern on the wafer.

At present, several methods for position detecting of the alignment mark on the wafer is practically used. However, in any method, waveforms of the detection result signals obtained by using the position detecting apparatus is analyzed to detect the positions of the alignment marks with the
predetermined forms on the wafer. For example, recently, the position detecting method depends on the image processing became major. In this method, optical images of the alignment marks are picked-up by using the image pick-up unit, and the signal of the picked-up image, that is, the distribution of light intensity of the image is then analyzed to detect the positions of the alignment marks. As such alignment marks, for example, the line and space mark is used. In the line and space mark, line patterns and space patterns are arranged mutually along a predetermined direction.

In the position detection using the image processing, it is premising that the line pattern and the space pattern can be distinguished in the picked-up image of the mark. However, recently flattening techniques such as the chemical mechanical polish (to be referred to as "CMP") are advanced, depending on the production of the semiconductor device with highly integrated or fine circuit patterns. Thereby, the height difference between the line pattern and the space pattern becomes smaller, and it causes low contrast of the line pattern and the space pattern in the picked-up image. As a result, the border between the line pattern and the space pattern (to be referred to as an "edge" hereinafter) is sometimes not clearly distinguished, in which the edge is the quite important factor for detecting the mark position.

On the contrary, when the image of the mark with the small height difference is picked-up, increasing gradually the plus or minus defocus amount from the focus states, the image of the mark as the image pick-up result is gradually blurred. However, the contract between the line pattern and the space pattern is gradually enhanced, and then sometimes decreased, that is, the defocus states sometimes appears. In the defocus states, the contrast of the line pattern and the space pattern is larger than the focus states. Therefore, the technique for detecting the position of the marks is disclosed, for example, in the publication of Japanese unexamined patent application (refer to as "Japan laid-open", hereinafter) No. S62-278402. In this technique, the defocus position with high contrast is searched based on the change of the image of the mark obtained from varied defocus amount to obtain the signal waveform at the searched position. Then the position of the mark is detected by using the obtained signal waveform.

The mark position detected by such conventional arts is that detected based on the signal waveform of the image pick-up result at the defocus state in which the contrast between the line pattern portion and space pattern portion is secured. That is, the mark position detected by the conventional arts is that obtained by using signal waveform at the defocus state. The mark position detected by the conventional arts is not always the same as the position, which should be obtained by using the signal waveform at the focus state.

This is caused by the following reasons:

(a) when the wafer and the imaging plane is relatively moved in the defocus direction, it is difficult to restrict the relative movement between the wafer and the imaging plane in the defocus direction correctly, (b) it is impossible that the tilt of the imaging optical system between the wafer and the image pick-up plane is strictly set zero, (c) it is not limited that the aberration at the defocus state is not always isotropically generated. That is, from the above-mentioned reasons, the image of the mark at the defocus state is moved in the image pick-up plane, the magnification of the image of the mark in the transversal direction is not even in the image pick-up plane, or varies depending on the defocus amount.

On the contrary, there are needs, for example, to perform higher integration of the semiconductor device or forming finer patterns on it. Therefore, it is unavoidable that the height difference in the positioning mark tends to low. In addition, there are needs for improving the detection accuracy of the positioning mark. In brief, it is expected for the new technology that pertains the positional detection with high accuracy of the mark having low height difference.

The present invention is made under the above-mentioned situation. The purpose of the present invention is to provide the position detecting methods and the apparatuses thereof for detecting the positional information of the mark formed on the substance precisely.

Another purpose of the present invention is to provide the exposure methods and the exposure apparatuses for transferring the predetermined pattern to the substrate accurately.

Yet another purpose of the present invention is to provide the device manufacturing methods for manufacturing the highly integrated device with fine patterns.

In the first aspect of the present invention, the present invention is a position detecting method for detecting positional information of a mark formed on a substance, comprising the steps of: picking-up at least one image of the mark under the image pick-up condition including a plurality of defocus states; obtaining a relationship between picked-up image state of said mark and said defocus amount, based on image pick-up results in the image pick-up condition; and detecting the positional information of the mark based on the relationship.

According to this, after the plural marks are picked-up under the image pick-up condition including the plural defocus states, the relationship between the picked-up image of the mark and the defocus amount is obtained. The relationship is the manner in the change of the picked-up image of the mark depending on the varied defocus amount. From the relationship between the obtained picked-up image of the mark and the defocus amount, the positional information of the mark is estimated. In other words, the positional information of the mark is that should be obtained by using the image of the mark at the focus state. Accordingly, even when the contrast between the line pattern portion and the space pattern portion in the picked-up image of the mark at the focus state is low, the positional information of the mark is precisely detected.

In the position detecting method according to the present invention, the image of the mark might be picked-up on an image pick-up plane, which tilts against an imaging plane on which the image of the mark is formed. In this case, since the defocus state varies along the tilt direction against the imaging plane in the image pick-up plane, the image pick-up of the mark including plural defocus states might be completed by the single operation.

In the position detecting method according to the present invention, the positional information of the characterized point at the focus state is estimated based on the image picked-up results at a plurality of said defocus states. The "characterized point" is defined as the local maximum point or local minimum point (to be referred to as the "local maximum or minimum point", hereinafter), or the point should be the point of inflection. Such "characterized points" are usually coincident with those in the mark figure. For example, in the above-mentioned edge portion, the characterized point is the local maximum or minimum point of the first order differential signal for the image pick-up signal of the mark. In the specification, the "characterized point" means that of the mark as described above.

In such cases, the positional information of the characterized point at a focus state is estimated based on the image pick-up results at a plurality of the defocus states. The estimation is performed based on the varying manner of the position of the characterized point at the defocus states, depending on the defocus amount.

The positional information of the characterized point at a focus state might be estimated, considering a respective contrast of image pick-up results at a plurality of the defocus states. In such cases, the likelihood of the characterized point position at the defocus states are considered based on the contrast of the image pick-up results at the defocus states. In other words, the positional information of the characterized point is well evaluated when it is obtained from the image pick-up results with high contrast and its likelihood is high, and it is poorly evaluated when it is obtained from the image pick-up results with low contrast and its likelihood is low. As a result, the likelihood of the characterized point is reasonably evaluated and the mark position is detected.

In the above description, the positional information of the mark is detected by sole image pick-up results at the defocus state. On the contrary, when the contrast between the line pattern portion and the space pattern portion in the image pick-up result at the focus state is not enough, but a certain amount of the contrast is secured, the image pick-up result at the focus state might be further used. That is, in the position detecting method of the present invention, it is possible that the image pick-up condition further comprises a focus state, and the obtaining relationship comprises the steps of: estimating a positional information of the characterized point at the focus state using the picked-up image at a plurality of defocus states; and further estimating the positional information of the characterized point at the focus state using the picked-up image at the focus state.

In the detection of the positional information, the a positional information of the above-described mark might be estimated, considering a respective contrast of image pick-up results at a plurality of defocus states and those at the focus state. In such cases, the likelihood of the estimated position at the states, which vary depending on the contrast at the image pick-up results, is considered. That is, the likelihood of the characterized point position, which is estimated based on the magnitude of the contrast, is also different as mentioned above. Therefore, the likelihood of the characterized point position, which is obtained from the image pick-up results at the plural defocus states or the focus states, is evaluated based on the contrast at the respective state.

The defocus states include either plus defocus state or minus defocus state, and a position of the characterized point at the focus state might be estimated by an extrapolation method using positions of the characterized point obtained from the image pick-up results at the defocus states.

Alternatively, a plurality of the defocus states include a plus defocus state and a minus defocus state, and a position of the characterized point at the focus state might be estimated by an interpolation method using positions of the characterized point obtained from the image pick-up results at the defocus states.

In the second aspect of the present invention, the present invention is the position detecting apparatus for detecting a positional information of a mark formed on a substance, comprising an imaging optical system for forming an image of the mark; an image pick-up unit for picking-up the image of the mark formed by the imaging optical system; and a processing unit for obtaining the relationship between picked-up image state of the mark and defocus amount based on the image pick-up results by using the image pick-up unit under the image pick-up condition including a plurality of defocus states.

With this, the image of the mark formed by the imaging optical system is picked-up by using the image pick-up unit under the image pick-up condition including the plural defocus states. Then, the processing unit obtains the relationship between the picked-up images of the marks and the defocus amounts based on the image pick-up results under the image pick-up conditions to detect the positional information of the marks based on the relationship. In other words, the positional information of the mark, which should be obtained by using the image of the mark at the focus state, is obtained. In brief, since the positional information of the mark might be detected by using the position detecting method of the present invention, the positional information of the mark is precisely detected even when the contrast between the line pattern portion and the space pattern portion in the image which is picked-up at the focus state.

In the position detecting apparatus according to the present invention, the surface condition of the mark varies along the predetermined direction, and the image pick-up unit might comprise a image pick-up plane which is rotated around a direction in an imaging plane on which the image is formed by the imaging optical system corresponding to the predetermined direction. In such cases, the defocus state is varied along the tilt direction against the imaging plane in the image pick-up plane so that the image pick-up under the imaging condition including the plural defocus states might be performed by single operation.

In the position detecting apparatus, it might have the structure that the image pick-up plane intersects the imaging plane. In such cases, the defocus states include plus defocus states and minus defocus states. Therefore, a position of the characterized point at the focus state might be estimated by an interpolation method using positions of the characterized point obtained from results at the defocus states.

The position detecting apparatus according to the present invention might be the structure, which further comprising: a tilt adjustment mechanism for adjusting rotation amount of an image pick-up plane of said image pick-up unit around a direction in an imaging plane on which the image is formed by said imaging optical system corresponding to the predetermined direction. In such cases, depending on the height difference between the line pattern portion and the space pattern portion in the mark, the tilt adjusting mechanism might adjust the tilt of the image pick-up plane against the imaging plane to generate simultaneously the plural defocus states on the image picked-up plane. Such defocus states are necessary for precise detection of the positional information of the mark. Accordingly, the positional information of the mark is rapidly and precisely detected, in spite of the height difference between the above portions.

The position detecting apparatus according to the present invention might use the structure that further comprising: a moving mechanism for relatively moving a imaging plane, on which the image of the mark is formed by the imaging optical system, and the image pick-up plane of the image pick-up unit along the optical axis direction of the imaging optical system. In such cases, the moving mechanism relatively moves the imaging plane for the image of the mark and the image pick-up plane along the optical axis direction of the imaging optical system. Thereby the plural defocus states, which are necessary for the detection of the positional information of the mark, might be sequentially generated on the image pick-up plane. Accordingly, the positional information is rapidly and precisely detected, in spite of the height difference between the above portions.

In the third aspect of the present invention, the present invention is "an exposure method for transferring a predetermined pattern to a divided area on a substrate, comprising the steps of: detecting a positional information of marks formed on the substrate for a position detection by using said method according to the present invention, obtaining a predetermined number of parameter for a position calculation of the divided area, and calculating an arrangement information of the divided area on the substrate; and transferring the pattern to the divided area while controlling a position of the substrate, based on the arrangement information of the divided area".

According to this, by using the position detecting method of the present invention, the positional information of the position detection marks formed on the substrate is detected in high accuracy to calculate the arrangement coordinate of the divided area on the substrate based on the detection result. Then the pattern on the substrate is transferred onto the divided area, positioning the substrate based on the calculated result of the arrangement coordinate. Accordingly, the predetermined pattern is precisely transferred on to the divided area.

In the fourth aspect of the present invention, the present invention is "an exposure apparatus for transferring the predetermined pattern to a divided area on a substrate, comprising: a stage unit for moving the substrate along a moving plane; and a position detecting apparatus according to the present invention for detecting the positional information of the marks on the substrate mounted on the stage unit. With this, by using the position detecting apparatus of the present invention, the positional information of the mark on the substrate as well as that of the substrate are precisely detected. Thereby, the stage unit can move the substrate based on the precisely obtained position of the substrate. As a result, the predetermined pattern can be transferred onto the divided area on the substrate in improved accuracy.

In the fifth aspect of the present invention, the present invention is a making method of an exposure apparatus for transferring a predetermined pattern to a divided area on a substrate, comprising the steps of: providing a stage unit for moving the substrate along a moving plane; and providing a position detecting unit for detecting a positional information of a mark on said substrate, and for being mounted on the stage unit, wherein the position detecting unit comprises: an imaging optical system for forming an image of the mark, formed on the substrate; an image pick-up unit for picking-up a image formed by the imaging optical system; and a processing unit for obtaining a relationship between picked-up image state of the respective mark and defocus amount based image pick-up results by using the image pick-up unit under an image pick-up condition including a plurality of defocus states, and detects positional information of the marks based on said relationship". According to this, in the making method of the exposure apparatus of the present invention, the stage unit and the position detecting apparatus are provided. The stage unit is used for moving the substrate along the moving plane, and the position detecting apparatus is used for detecting the positional information of the mark formed on the substrate, which is mounted on the stage unit. The exposure apparatus produced by connecting other components mechanically, optically and electrically, and then totally adjusted with the above-mentioned units is provided.

When the position detecting apparatus is structured as the computer system, the computer system might execute the position detecting method of the present invention by reading out the control program for controlling the execution of the position detecting method of the present invention. Accordingly, from the other viewpoint, the present invention is also the computer readable recording medium in which the control program for controlling the use of the position detecting method of the present invention is stored.

In the lithography step, the plural layered fine patterns might be formed on the substrate with highly superposed accuracy. With this, more highly integrated micro devices can be produced, and their productivity is enhanced. Accordingly, from the other viewpoint, the present invention is also the device manufacturing method by using the exposure methods of the present invention.

Fig. 1 is a view showing the schematic arrangement of an exposure apparatus according to an embodiment of the present invention;

Figs. 2A to 2C are views for showing the configuration of the alignment system shown in Fig. 1;

Figs. 3A and 3B are views for explaining as an example of alignment marks;

Figs. 4A to 4D are views for explaining image pick-up results for the alignment marks;

Figs. 5A to 5E are flow chart for explaining the process for forming the mark through CMP process;

Fig. 6 is a view showing the schematic arrangement of a main control system;

Fig. 7 is a flow chart for explaining a position detecting operation of the mark;

Figs. 8 is a view for explaining the generating state of the defocus amount on the image pick-up plane when the image is picked-up;

Figs. 9A and 9B are views for explaining the way to obtain a signal waveform in respective defocus amount;

Fig. 10 is a view for explaining the way to estimate positions of characterized points at the focus state;

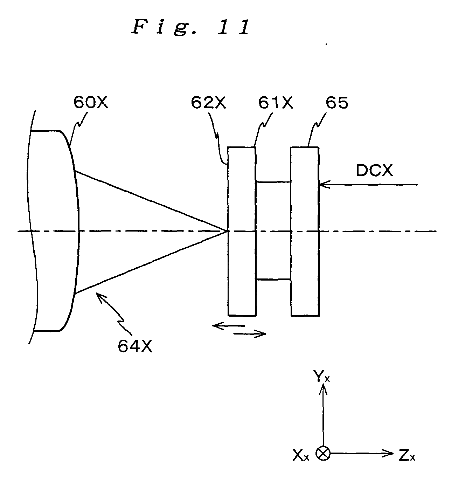

Fig. 11 is a view showing modified embodiment of the present invention;

Fig. 12 is a flow chart for showing the device manufacturing method by using the exposure apparatus in Fig. 1; and

Fig. 13 is a flow chart of the processing in a wafer processing step shown in Fig. 12.

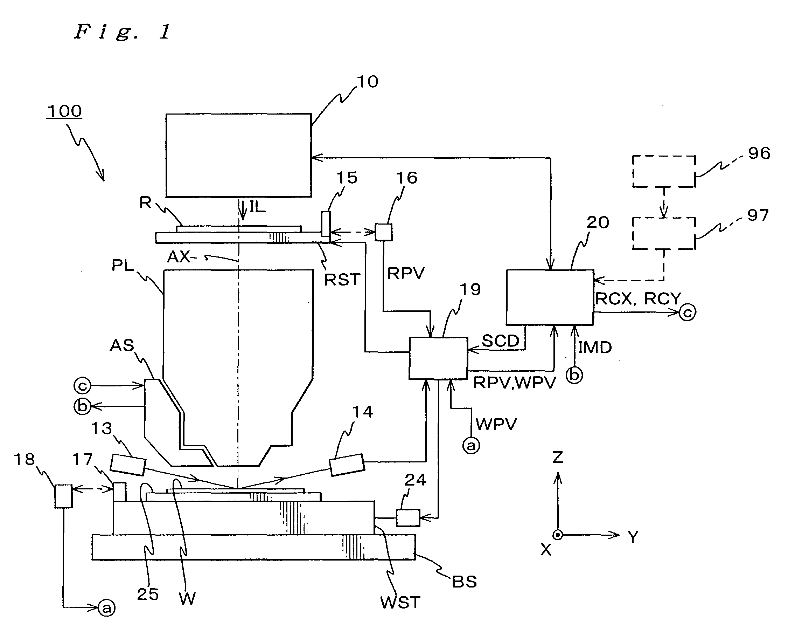

An embodiment of the present invention will be described below with reference to Figs. 1 to 10.

Fig. 1 shows the schematic arrangement of the exposure apparatus 100 according to one embodiment of the present invention. The exposure apparatus 100 is a step-and-scan type projection exposure. The exposure apparatus 100 comprises: the illumination system 10 for emitting illumination light for exposing the wafer; reticle stage RST serving as a mask stage for holding the reticle R as a mask; a projection optical system PL; the wafer stage WST for mounting a wafer on it; the wafer W (as a sample for the substrate or substance); the alignment system AS as an image pick-up unit, and the main control system 20 for controlling the entire of the apparatus.

The illumination system 10 includes: a light source, the illumination averaging optical system composed of a fly eye lens and so forth, a relay lens, a variable ND filter, a reticle blind, and an dichroic mirror (all of which are not shown in Figs.). The structure of the illumination system is disclosed, for example, in the publication of Japanese unexamined patent application (refer to as "Japan laid-open", hereinafter) No. H10-112433. The disclosure described in the above is fully incorporated by reference herein. In the illumination system 10, the illumination light IL illuminates the illumination area with slit form defined by the reticle blind on the reticle R on which a circuit pattern is drawn.

The reticle R is fixed on the reticle stage RST, for example, by vacuum chucking. In order to position the reticle R, the reticle stage RST is driven by the reticle stage driving unit composed of two dimensional magnetic floating type linear actuator, which is not shown in Figs. The reticle stage RST is structured so that it can be finely driven in the X-Y plane which is perpendicular to an optical axis of the illumination system 10 (the optical axis is coincident with another optical axis AX of the optical projection system PL described in below) , and it can drive to the predetermined direction with designated scanning velocity, wherein it is the Y-axis direction. Furthermore, in this embodiment, since the above-mentioned two-dimensional magnetic floating type linear actuator includes the coil for driving RST in Z-direction except two coils for driving RST in the X-direction and Y-direction so that the linear actuator can finely drives RST in the Z-direction.

The reticle laser interferometer (to be referred to as a "reticle interferometer" hereinafter) 16 detects the position of the reticle stage RST within the stage moving plane at all times by for a moving mirror with the resolution of, for example, about 0.5 to 1 nm. Positional information (or velocity information) RPV of the reticle stage RST is transmitted from the reticle interferometer 16 to a stage control system 19. The stage control system 19 drives the reticle stage RST through a reticle driving portion (not shown in Figs.) by using the information RPV of the reticle stage RST. The information RPV of the reticle stage RST is transmitted to the main control system 20through the stage control system 19.

The projection optical system PL is arranged below the reticle stage RST in Fig 1. The direction of the optical axis AX of the projection optical system PL is the Z-axis direction. As the projection optical system PL, a refraction optical system is used, which is in double telecentric, and having a predetermined projection magnification of, for example, 1/5 or 1/4. Therefore, when the illumination area of the reticle R is illuminated with the illumination light IL from the illumination optical system, a reduced image (partial inverted image) of the circuit pattern of the reticle R in the illumination area IAR is formed on the wafer W, of which surface is coated with a photo-resist.

The wafer stage WST is arranged below the projection optical system PL in Fig. 1, and on base BS. The wafer holder 25 is mounted on the wafer stage WST. The wafer W as a substrate is held on the wafer holder 25 by, for example, vacuum chucking. The wafer holder 25 is structured so that it is tilted in the desirable direction against the orthogonal plane of the light axis, and is finely driven to the AX direction of the light axis of the projection optical system PL (Z-direction). The wafer holder 25 is driven around the AX direction of the light axis of the projection optical system PL.

The wafer stage WST is structured to be moved in the perpendicular direction to the scanning direction (X-direction) so that the wafer stage WST is also moved in the scanning direction (Y-direction) to be positioned in the exposure area which is conjugate to the above-mentioned illumination area. The wafer stage WST performs so-called step-and-scan operation motion in which the scanning exposure of the shot area on the wafer W and moving to the exposure starting position of the next shot area are repeated. The wafer stage WST is driven in the XY-two dimensional direction by using the wafer stage driving portion 24.

The wafer interferometer 18 arranged externally detects the position of the wafer W in the X-Y plane through the moving mirror 17 at all times with the resolution of, for example, about 0.5 to 1 nm. Positional information (or velocity information) WPV of the wafer stage WST is sent to a stage system 19. The stage control system 19 drives the wafer stage WST by using the positional information WPV of the wafer stage WST. The positional information WPV of the wafer stage WST is transmitted to the main control system 20through the stage control system 19.

The above-mentioned alignment system AS is an off-axis alignment sensor arranged at the side of the projection optical system PL. The alignment system AS outputs the picked-up image of the alignment marks (wafer marks) associated beside each shot area on the wafer W. These image pick-up results are sent to the main control system 20as the image pick-up data IMD.

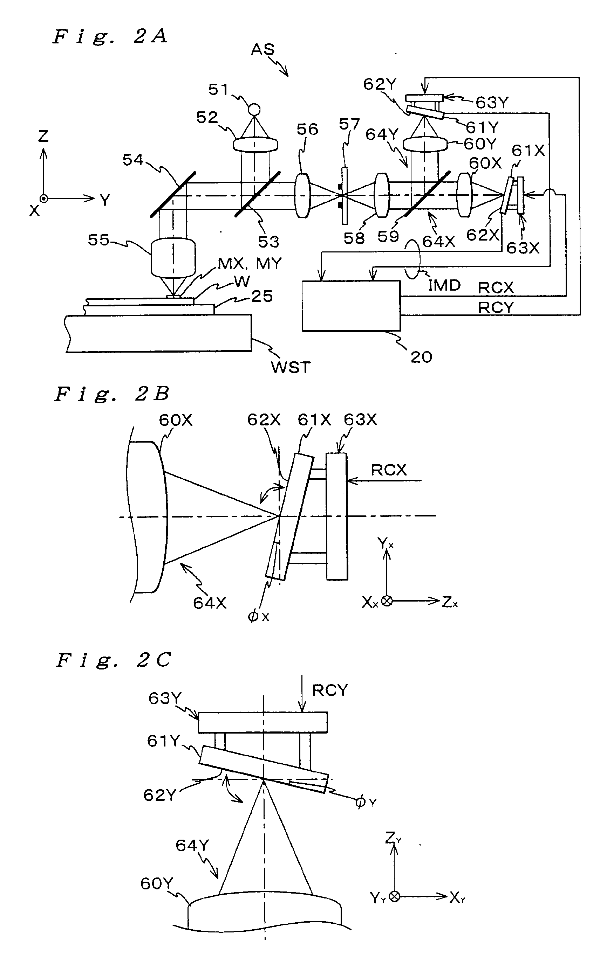

As shown in Fig. 2A, the alignment system AS includes: the light source 51, the collimator lens 52, the beam splitter 53, the mirror 54, the objective lens 55, the collective lens 56, the index plate 57, the first relay lens 58, the beam splitter 59, the second relay lens for the X-axis 60X, the image pick-up device for X-axis 61X comprising two dimensional CCD with the image pick-up plane 62X, the tilt control mechanism 63X, the second relay lens for the Y-axis 60Y, the image pick-up device for Y-axis 61Y comprising two dimensional CCD with the image pick-up plane 62Y, the tilt control mechanism 63Y, and so forth. Each part of the structure for the alignment system AS is explained with its operation herein below.

The light source 51 emits light that causes no reaction in the photoresist on the wafer, and it has the broad wavelength distribution with a certain band width (for example, about 200 nm) . Particularly, halogen lumps might be preferably used as the light source 51. In order to prevent for decreasing the detection accuracy of the mark caused by the thin film interference in the photoresist layer, it is preferable to use the illumination light with enough broader band width.

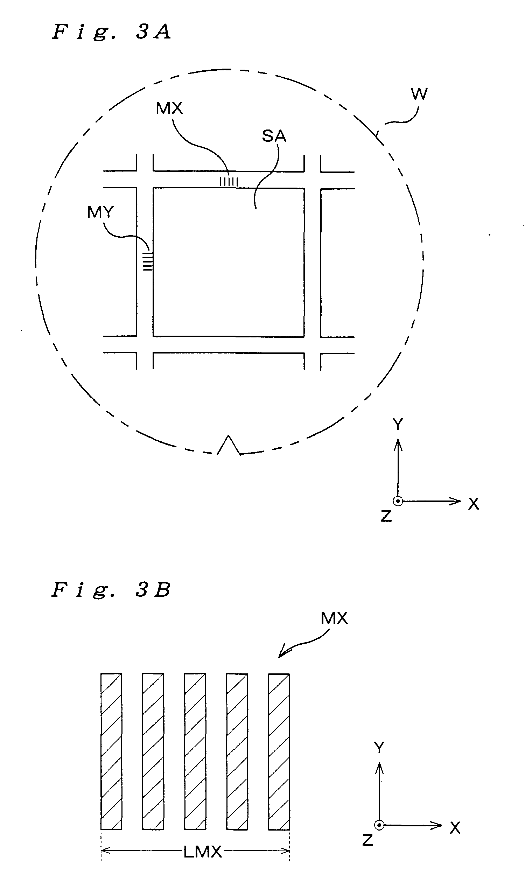

The illumination light from the light source 51 is illuminated near by the alignment marks MX and MY on the wafer W sequentially through the collimator lens 52, the beam splitter 53, the mirror 54, and objective lens 55 (see Fig. 3). Then, the reflection light from the alignment mark MX or MY reaches the index plate 57 sequentially through the objective lens 55, the mirror 54, the beam splitter 53, and the collective lens 56 to form the image of the alignment marks MX and MY on the index plate 57.

The light passed through the index plate 57 goes toward the beam splitter 59 through the first relay lens 58. Then, the light passes through the beam splitter 59 is focused on the image pick-up plane 62X of the image pick-up device for X-axis 61X by the second relay lens 60X for X-axis 60X. On the contrary, the reflected light by the beam splitter 59 is focused on the image pick-up plane 62Y of the image pick-up device for Y-axis 61Y by the second relay lens for Y-axis 60Y. As a result, on the image pick-up plane 62X or 62Y of the image pick-up device 61X or 61Y, the image of the alignment mark MX or MY superposed with that of the index mark on the index plate 57 is projected. The imaging optical system for the mark MX 64X is composed of the objective lens 55, the collective lens 56, the first relay lens 58, and the second relay lens for X-axis 60X. The imaging optical system for the mark MY 64Y is composed of the objective lens 55, the collective lens 56, the first relay lens 58, and the second relay lens for Y-axis 60Y.

As shown in Fig. 2B, depending on the tilt data RCX from the main control system20, the tilt adjusting mechanism 63X rotates the image pick-up device 61X (in the rotation angle $\phi_X$) around the $X_X$-axis of the conjugate coordinate system $(X_X, Y_X, Z_X)$ of the wafer coordinate system $(X, Y, Z)$, which pertains to the imaging optical system for the mark MX. Thereby, the tilt amount of the image pick-up plane 62X against the imaging plane for the image of the mark of the imaging optical system for the mark MX 64X is adjusted. As shown in Fig. 2C, depending on the tilt data RCY from the main controller 20, the tilt adjusting mechanism 63Y rotates the image pick-up device 61Y (the rotation angle is $\phi_Y$) around the $X_Y$-axis of the conjugate coordinate system $(X_Y, Y_Y, Z_Y)$ of the wafer coordinate system $(X, Y, Z)$, which pertains to the imaging optical system for the mark MY. Thereby, the tilt amount of the image pick-up plane 62Y against the imaging plane of the image of the mark of the imaging optical system for the mark MY 64Y is adjusted.

As described above, the images of the marks on the image pick-up planes 62X and 62Y, of which tilt amount is thus adjusted, are picked-up by using the image pick-up devices 61X and 61Y, and the image pick-up data IMD, the image pick-up results, are transmitted to the main controller 20. When the object of the image pick-up is the mark MX, the image picked-up result obtained by the image pick-up device 61X is solely transmitted to the main control system 20as the image pick-up data IMD. On the contrary, when the object of the image pick-up is the mark MY, the image picked-up result obtained by the image pick-up device 61Y is solely transmitted to the main control system 20as the image pick-up data IMD.

As alignment marks, for example, the mark MX and the mark MY are used. Both the marks are formed on the street line around the shot area SA on the wafer shown in Fig. 3A, and the mark MX is used for position detection in X-direction and the mark MY is used for position detection in Y-direction. As respective mark MX and MY, for example, the line and space mark might be used which has periodic structure along the direction of the position detection, as typically shown as the magnified mark MX in the Fig. 3B. The alignment system AS outputs the image pick-up data IMD as the image pick-up result to the main control system 20 (see Fig. 1). In Fig. 3B, the line and space with five lines is shown, but the line numbers in the line and space mark employed as the mark MX (or the mark MY) is not limited to five, and other numbers can be used. In the following explanation, the mark MX or MY is described as the mark MX (i, j) or the mark MY(i, j) corresponds to the arrangement position of the coincident shot area, when the respective mark MX or MY is shown.

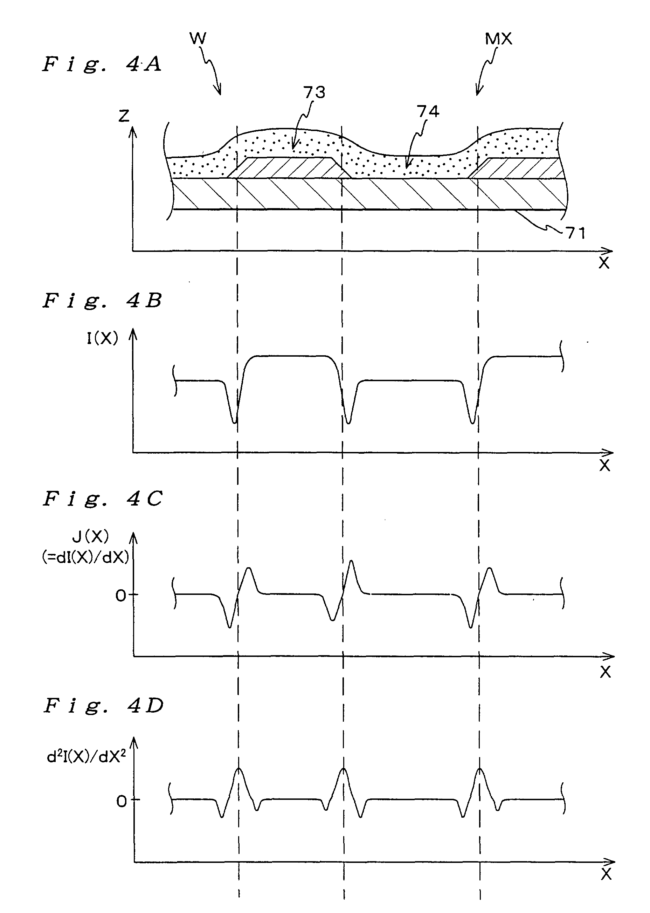

In the formation area of the mark MX on the wafer, as shown in X-Z cross sectional plane in Fig. 4A, the line pattern 73 and the space pattern 74 are formed mutually in X-direction on the surface of the base layer 71, and the photoresist layer covers the line pattern 73 and the space pattern 74. The materials used for the photoresist layer are, for example, the positive type photoresist material and the chemically amplified type photoresist, and those have high optical transparency. The materials used for forming the base layer 71 and the line pattern 73 are different, and reflection factor or transmission factor of those material are generally different. In this embodiment, the material for the line pattern 73 has high reflection factor, and that for the base layer 71 has lower reflection factor than that for the line pattern 73. The upper surfaces of the base layer 71 and line pattern 73 are almost flat.

The distribution of light intensity I for the image in X-direction I (X) is that shown in Fig. 4B on its design, when the image formed by the reflection light on the formation area of the mark MX, which is illuminated by the illumination light from the upper side, is observed. That is, in the observation image, the light intensity I is the most large and stable at the coincide position with the upper surface of the base layer 71. The light intensity I is the second most large and stable at the coincide position with the upper surface of the line pattern 73. Between the upper surface of the line pattern 73 and the base layer 71, the light intensity changes so that it draws J-form (or its mirrored form) when the intensity is plotted. The template waveform of the first order differential waveform $d(I(X)/dX)$ (to be referred to as the "$J(X)$", hereinafter) and the template waveform of the second order differential waveform $d^2(I(X)/dX^2)$ for the signal waveform (the raw waveform) shown in Fig.4B are shown in Figs. 4C and 4D. In the embodiment, the first order waveform $J(X)$ is analyzed to detect the position of the mark MX. The X-position is detected also for the mark MY by analyzing the first order of the differential waveform of the raw waveform $J(X)$.

The mark MY is also similarly structured, except that the arrangement direction of the line pattern and the space pattern is Y-direction. The Y-position is detected also for the mark MY by analyzing the first order of the differential waveform of the raw waveform $J(X)$.

Recently, since the circuit of the semiconductor became finer, in order to form the fine circuit pattern more precisely, the process for averaging the surface of each layer formed on the wafer W has been employed. The representative process is CMP process (chemical and mechanical polishing process), in which polishing the surface of the film formed to flatten the coating surface. CMP process is sometimes applied on the inter-layer insulating film (which is made of dielectric substances such as silicon dioxide) in the wiring layers (which is made of metals) of the semiconductor integrated circuit.

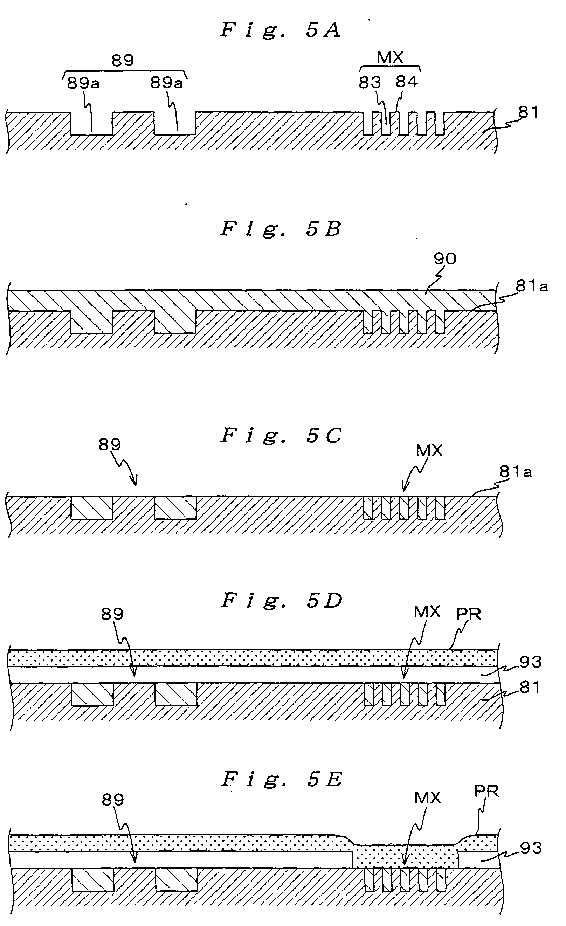

Recently, in order to insulate, for example, adjoining fine elements, Shallow Trench Isolation (STI) process is developed. In STI, the predetermined shallow trench is formed, and the insulation film made of the dielectrics or the like is embedded in the trench. In STI process, the surface of the layer in which the insulation material is embedded is flattened by using CMP process, and then, the polycrystalline silicon (to be referred to as "poly-silicon" hereinafter) film is formed on the surface. For the mark MX formed through such processes, the case that other patterns are formed simultaneously is explained, referring to Figs. 5A to 5E.

First of all, as the cross sectional view shown in Fig. 5A, the mark MX and the circuit pattern 89, more precisely, the concave portion 89a, are formed on the silicon wafer 81. The mark MX comprises a concave portion corresponds with the line portion 83 and a convex portion corresponds with the space portion 84.

Then, as shown in Fig. 5B, the insulation film 90 which is composed of dielectric material such as silicon dioxide ($SiO_2$) and so forth is formed on the surface 81a of the wafer 81. Subsequently, as shown in Fig. 5C, CMP process is applied on the surface of the insulation film 90 to delete the film until the surface 81a of the wafer 81 is appeared, and the surface 81a is flattened. As a result, the circuit pattern 89 is formed in the circuit pattern area, and the insulation film 90 is embedded in the concave portion 89a of the circuit area. The mark MX is formed in the mark MX area, and the insulation film 90 is embedded in the plural line portion 83.

Then, as shown in Fig. 5D, the poly-silicon film 93 is formed on the upper layer of the wafer surface 81a of the wafer 81. On the poly-silicon film 93, photoresist PR is coated.

The concave and convex, which reflect the structure of the mark MX formed in the under layer, is not entirely formed on the surface of the poly-silicon layer 93, when the mark MX formed on the wafer 81 as shown in the Fig. 5D by using the alignment system AS. The luminous flux with predetermined wave range, visible light of which wave length is 550 to 780 nm, does not pass through the poly-silicon layer 93. Therefore, the mark MX is not detected by using the alignment manner, which uses the visible light as the detection light. Alternatively, there is the possibility that the detection accuracy might be low in the alignment manner caused by reducing the amount of the light as the detection light for the alignment, of which major part is occupied in the visible light.

In Fig. 5D, the metal film (metal layer) 93 might be formed instead of the poly-silicon layer 93. In this case, the concave and convex which reflect the alignment mark formed in the under layer is not entirely formed on the metal layer 93. In general, since the detection light for the alignment does not pass though the metal layer, there is the possibility that the mark MX might not be detected.

As mentioned above, in order to observe the wafer 81 on which the poly-silicon layer 93 is formed (shown in Fig. 5D) by using the alignment system AS, the mark MX might be observed, after the detection light is set to the light except the visible light (for example, the infrared rays of which wavelength is 800 to 1500 nm) if the light may be changeable, selectable or optionally set.

When the wavelength of the alignment detection light can not be elected or the metal layer 93 is formed on the wafer 81 passed through CMP process, as shown in Fig. 5E, the area of the metal layer 93 correspond with that the mark MX is peeled off by using photolithography and then the area is observed by the alignment system AS.

The mark MY is formed in the same manner as the above-mentioned mark MX via CMP process.

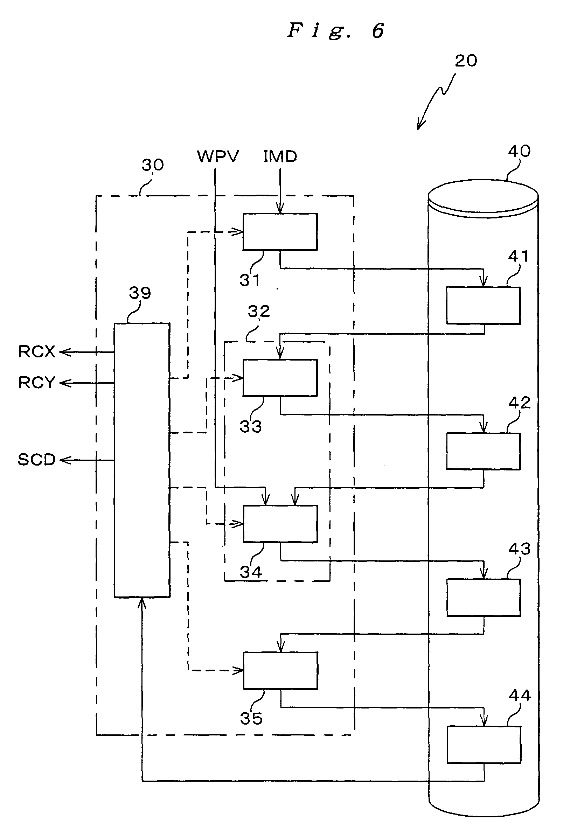

As shown in Fig. 6, the main control system 20comprises the main control unit 30 and the storage unit 40. The main control unit 30 transmits the tilt control data RCX and RCY, and it comprises: the control unit 39 for controlling the operation of the exposure apparatus 100 by transmitting the stage control data SCD to the stage control system 19; the image pick-up data collecting unit 31 for collecting the image pick-up data from the alignment system AS; the positional operating unit 32 for analyzing the image pick-up data IMD collected by using the image pick-up collecting unit 31 to obtain the estimated position of the alignment marks MX and MY; the parameter calculating unit 35 for calculating parameters to define the arrangement coordinates of the shot area SA based on the positions of the alignment marks MX and MY obtained by using the positional operating unit 32. The position operating unit 32 comprises: the characterized point extracting unit 33 for extracting the position of the characterized point at every defocus state; and the position calculating unit 34 for calculating the positions of the alignment marks MX and MY, based on the positions of the characterized points at every defocus state.

The storage unit 40 comprises the followings in its inside: the image pick-up data storage area 41 for storing the image pick-up data IMD; the characterized point position storage area 42 for storing the position of the characterized point at every defocus state; the mark position storing area 43; and the parameter storing area 44.

In Fig.6, arrows drawn with the solid lines show the data flow, and those drawn with the dotted lines show the control flow. Operation of each unit included in the main control system 20 is explained in the latter part.

As mentioned above, in the present embodiment, the main control unit 30 is structured in combination of the various units. However, the main control system 20 might be structured as a computer system, and the function of each unit, which composes the main control unit 30, is achieved by the installed program in the main control system 20.

When the main control system 20 is structured as the computer system, it is not necessary to install all programs to achieve the function of the above-mentioned apparatus which structure the main control system 20 and the function of them are explained in below. For example, the following structure might be employed: a recording medium 96 in which the program is stored is prepared, it is shown in Fig. 1 as a box with the dotted lines; the medium 96 is inserted into and taken out from the reader unit 97, which is used to read out the contents of the program stored in the medium 96; the reader unit 97 is connected to the main control system 20 to read out the contents of the program from the medium 91 inserted into the reader unit 97 to execute the program.

Additional structure may be employed such that the main control system 20 reads out the contents of the program from the media 96 that is inserted into the reader unit97 to install them in the system 20. Furthermore, another structure may be employed to install the contents of the program necessary for achieving the function in the main control system 20via the communication network by using the internet or the like.

As the recording medium 96, various kinds of media might be used in which storing of information are varied magnetically (a magnetic disk, magnetic tape, or the like), electrically (PROM, RAM with buttery back up, EEPROM and other semiconductor memories), magneto-optically (magneto-optical disk or the like), electro-magnetically (digital-audio tape (DAT) or the like).

As mentioned above, the contents of the program used in below is easily amended, or version up for advancing its performance is also easily carried out, by structuring the system so that use the recording medium in which the contents of the program for achieving the desirable function or install them.

Back to Fig. 1, the illumination optical system 13 and the multi focal detection system with oblique incident light method are fixed on the support for supporting the projection optical system PL (not shown in Figs.) in the exposure apparatus 100. The illumination optical system 13 provides the luminous flux for image pick-up for forming multiple slit images to the best imaging plane of the projection optical system PL from the oblique direction against the optical axis AX. The multi focal detection system comprises the acceptance optical system 14 for accepting the reflection luminous flux of that of the image formation on the surface of the wafer W through the respective slit. As such multi focal detection system (13, 14), for example, the similarly structured system as disclosed in, for example, Japan laid-open No. H6-283403 and its corresponding U.S. Patent No. 5,448,332. The disclosure described in the above is fully incorporated by reference herein. The stage control system 19 drives the wafer holder 25 in Z-direct ion and the tilt direction based on the wafer positional information from the multi focal detection system (13, 14).

In exposure apparatus 100 structured as described above, the arrangement coordinate system of the shot area on the wafer W is detected in below. The arrangement coordinate is detected, premising that the marks MX (i, j) and MY (i, j) are previously formed on the wafer in the former layer forming process (for example, the first layer forming process) ; the wafer W is loaded on the wafer holder 25 by using the wafer loader which is not shown in figures; and the positioning with rough accuracy, pre-alignment is already performed, in which the wafer W is moved through the stage control system 19 by using the main control system 20 to catch the respective mark MX (i, j) and MY (i, j) in the observation field of the alignment system AS. The pre-alignment is performed through the stage control system 19 by using the main control system 20, more precisely the control unit 39, based on the observation for the outer shape of the wafer, the observation result for the marks MX(i, j) and MY(i, j) in the large field, and the positional information (or velocity information) from the wafer interferometer 18.

Alternatively, the height difference between the line pattern portion 83 and the space pattern portion 84 are already known and the height difference is almost coincident to the thickness of the line pattern portion 84. When the difference is existed, the changing state of the contrast between the line pattern portion 83 and the space pattern portion 84 derived from the change of the defocus amount is known. The tilt angle $\phi X_0$ of the image pick-up plane 62X and $\phi_{Y0}$ of the image pick-up plane 62Y are also known, and those tilt angles are preferably used for position detection of the marks MX(i, j) and MY(i, j). The height difference between the line pattern portion 83 and the space pattern portion 84 might be obtained by actual measurement, or by using the value of design. The tilt angles $\phi_{X0}$ and $\phi_{Y0}$ suitable for the position detection of the marks MX(i, j) and MY(i, j) might be obtained based on the result in which the image is picked-up, changing the tilt angle, or the calculation based on the mark figure information for the height difference and so forth.

Furthermore, X-alignment mark $MX(i_m, j_m)$ (m = 1 to M; M is not less than 3) and Y-alignment mark $MY(i_n, j_n)$ (n = 1 to N; N is not less than 3) are previously chosen. Those marks are measured for detecting the arrangement coordinate system of the shot area. The X-alignment marks $MX(i_m, j_m)$ are not arranged on a straight line from the viewpoint of design; and Y-alignment marks $MY(i_n, j_n)$ are neither arranged in the straight line. However, the total number of the chosen marks (= M + N) must be the number that is not less than five.

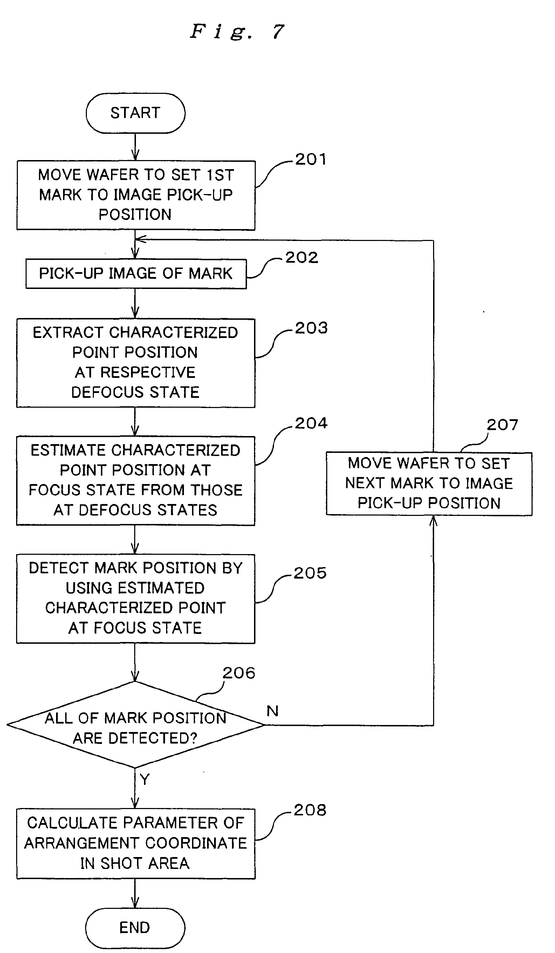

The detection of the arrangement coordinate of the shot area on the wafer W is explained according to the flow chart shown in Fig. 7, referring to other figures suitably.

First of all, in step 201 of the Fig. 7, the wafer W is moved so that the first mark (which is shown as X-alignment mark $MX(i_1, j_1)$) in the chosen marks $MX(i_m, j_m)$ and $MY(i_n, j_n)$ is set to the image pick-up position for the alignment system AS. The movement of the wafer W is performed under the control through the stage control system 19 by using the main control system 20 (in more precisely, the control unit 39). In parallel with the movement of the mark $MX(i_1, j_1)$ to the image pick-up position, the tilt angle $\phi_X$ of the image pick-up plane 62X for the mark MX within the range of the alignment system AS is set to the preferable tilt angle $\phi_{X0}$ for position detection as described above. The tilt angle is set by the main control system 20 (more precisely, the control unit 39), which controls the tilt control mechanism 63X. The tilt angle $\phi_Y$ of the image pick-up plane 62Y for image pick-up of the mark $MY(i_n, j_n)$ is also set to the preferable tilt angle $\phi_{Y0}$ for position detection as described above in step 201. The tilt angle $\phi_Y$ is set by the main control system 20 (more precisely, the control unit 39), which controls the tilt control mechanism 63Y.

As described above, the mark $MX(i_1, j_1)$ is set to the image pick up position in the alignment system AS, subsequently, in step 202, alignment system AS picks-up the image of the mark $MX(i_1, j_1)$ under the control of the control unit 39.

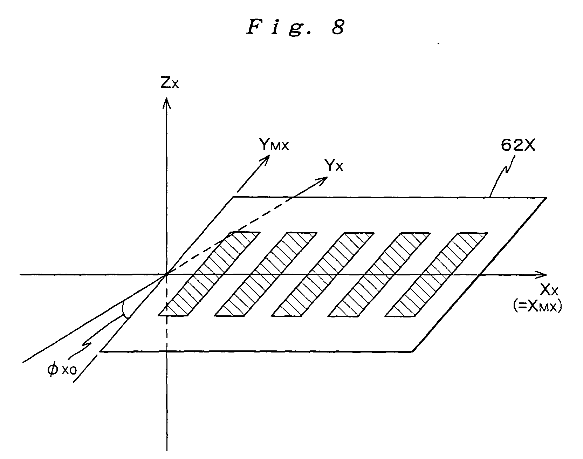

On the contrary, when the mark $MX(i_1, j_1)$ is set to the image pick-up position for the alignment system AS, as shown in Fig. 8, the image pick-up plane 62X has the tilt with the tilt angle $\phi_{X0}$ around $X_X$-axis to the $X_X$-$Y_X$ plane in the conjugate coordinate system $(X_X, Y_X, Z_X)$ of the wafer coordinate system $(X, Y, Z)$ as mentioned above. That is, the $X_X$-$Y_X$ plane is the imaging plane of the mark $MX(i_1, j_1)$ obtained from the imaging optical system for the mark MX. The coordinate position $(X_{MX}, Y_{MX})$ in the two-dimensional coordinate system $(X_{MX}, Y_{MX})$ defined on the imaging plane 62X in the conjugate coordinate system $(X_X, Y_X, Z_X)$ is obtained by using the following equations. Wherein, $X_{MX}$ axis is coincident to the $X_X$-axis.

$$X_X = X_{MX} \tag{1}$$

$$Y_X = Y_{MX} \cdot \cos \phi_{X0} \tag{2}$$

$$Z_X = Y_{MX} \cdot \sin \phi_{X0} \tag{3}$$

That is, in the image of the mark $MX(i_1, j_1)$ formed on the image pick-up plane 62X, the defocus amount DF $(Y_{MX})$ $(=Y_{MX} \cdot \sin \phi_{X0})$ is generated at the position in the two-dimensional coordinate system $(X_{MX}, Y_{MX})$ defined on the image pick-up plane 62X. On the image pick-up plane 62X, the image of the index mark is projected as the superposed one. However, the image of the index mark is not shown in Fig. 8.

By picking-up the image projected on the image pick-up plane 62X, the image of the mark $MX(i_1, j_1)$ (and the image of the index mark) is picked-up. The defocus amount at the image of the mark $MX(i_1, j_1)$ is continuously changing along the direction perpendicular to the $X_{MX}$-axis direction ($Y_{MX}$-axis direction), which is the conjugate direction of the X-axis for the mark $MX(i_1, j_1)$. Then, the imagepick-updatacollecting unit 31 incorporates the image pick-up data IMD, which is the image pick-up result derived from the alignment system AS, depending on the instruction from the control unit 39 to transmit them to the image pick-up data storage area 41 to collect the image pick-up data IMD.

Then, in step 203, the characterized point extracting unit 33 extracts the X-position of the characterized point at every defocus amount $DF_k$ (k = -K to K) obtained from the following equation (4), depending the instruction from the control unit 39.

$$DF_k = k \cdot \Delta DF \tag{4}$$

In the equation (4), $\Delta DF$ represents the interval of the predetermined defocus amount. The explanation in below is performed as K = 3, as one example.

In the extraction of the characterized point, the characterized point extracting unit 33 calculates the Y-position $Y_k$ on the image pick-up plane 62X according to the following equation (5), at Y-position $Y_k$ the above-mentioned defocus amount $DF_k$ is generated.

$$Y_k = DF_k / \sin \phi_{X0} \tag{5}$$

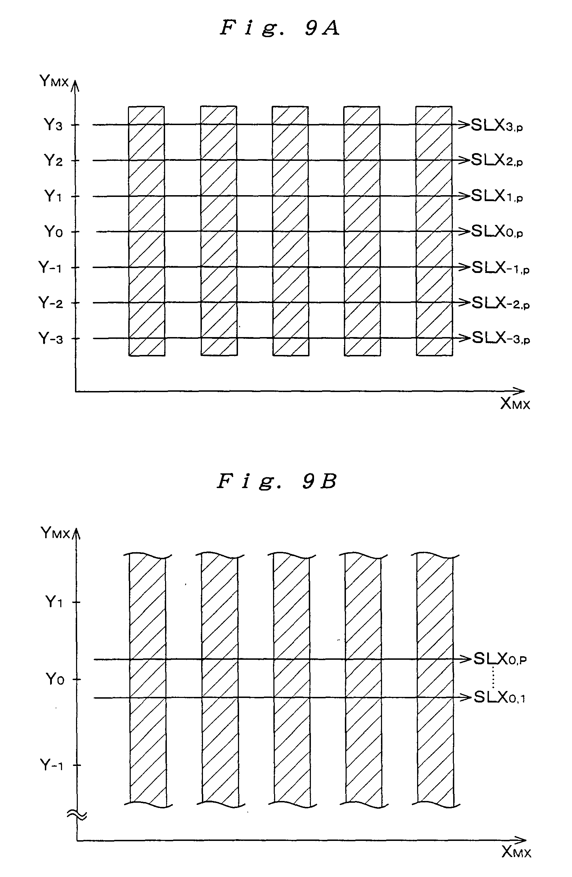

Subsequently, the characterized point extracting unit 33 reads out the image pick-up data IMD from the image pick-up data storing area 41 to extract the signal intensity distribution (light intensity distribution) $I_k(X_{MK})$ on the scanning line $SLX_{k,p}$ for $Y_{MX}$ position, $Y_k$, on the image pick-up plane 62X, as shown in Fig. 9A. In such extraction, the signal intensity distribution $I_{k,1}(X_{MK})$ to $I_{k,p}(X_{MK})$ on the scanning line $SLX_{k,p}$ (p = 1 to P) for the respective $Y_{MX}$ position, $Y_k$, on the image pick-up plane 62X is extracted. The extraction is performed on the plural number P (for example, P = 5) of the scanning line $SLX_{k,p}$ for the $X_{MX}$ direction, of which center is $Y_{MX}$ position, Yk, in $Y_{MX}$ direction. Then, the waveform of the signal intensity distribution $I_k(X_{MX})$ at the respective $Y_{MX}$ position, $Y_k$, in the $X_{MX}$ direction is obtained according to the following equation (6). The $X_{MX}$ positioning between the respective $Y_{MX}$ position, $Y_k$, is performed by setting the $X_{MX}$ position of the above-mentioned index mark as the same at $Y_{MX}$ position, $Y_k$.

$$I_k \ (X_{MK}) = (\sum_{i=1}^{P} I_{k,p} \ (X_{MK})) / P \tag{6}$$

Thus obtained signal waveform $I_k(X_{MX})$ has the decreased white noise or high frequency noise which are superposed on the signal intensity distribution $I_{k,1}(X_{MX})$ to $I_{k,p}$ $(X_{MX})$ respectively.

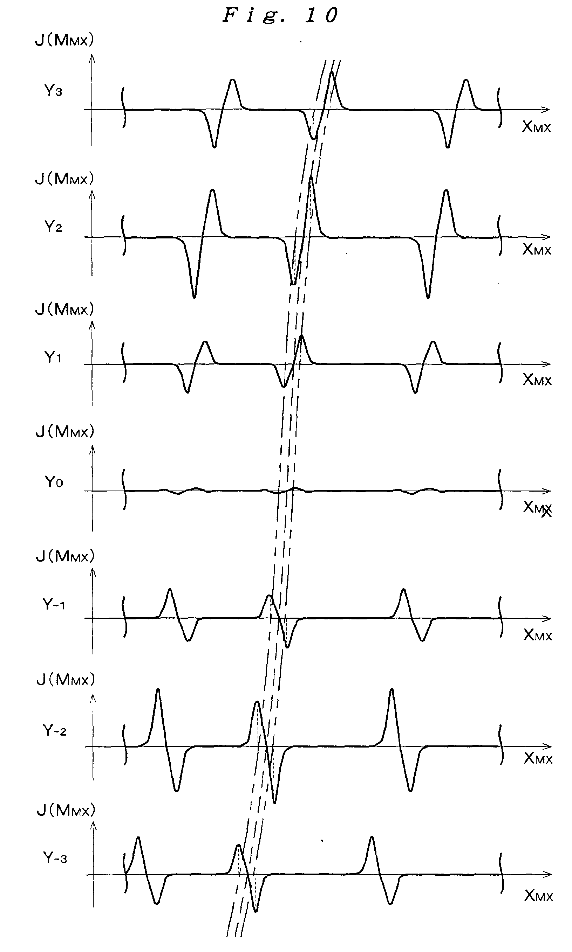

Then, the characterized point extracting unit 33 calculates the differential form $J_k(X_{MX})$ $(= dI_k(X_{MX}) /d(X_{MX}))$. Thus calculated differential waveform $J_k(X_{MX})$ is shown in Fig. 10. Subsequently, the characterized point extracting unit 33 extracts the $X_{MX}$ position of the characterized point to be peak for the respective differential waveform $J_k(X_{MX})$ to store them into the characterized point storing area 42.

Then, in step 204, based on the characterized point position at the defocus state depending on the defocus amount $DF_k$, the position calculation unit 34 estimates the position of the characterized point at the focus state, that is, the defocus amount is zero $(= DF_0)$.

When the characterized points are extracted, first of all, the position calculation unit 34 reads out the characterized point position at the respective defocus amount from the characterized point position storing area 42. Subsequently, the position calculating unit 34 estimates the locus drawn by the $X_{MX}$ position of the characterized point based on the corresponding $X_{MX}$ position of the characterized point between the defocus states. The characterized point is obtained at the respective defocus amount as the defocus amount is a variable. This estimation is performed, for example, by using the linear interpolation method or spline interpolation method. In this embodiment, the spline interpolation method is employed. Thus obtained locus depending on the changing of the defocus amount at the $X_{MX}$ position of the characterized point is shown in Fig. 10 by the double dotted lines.

Alternatively, in the above-mentioned interpolation to estimate the locus of the X-position of the characterized point depending on the defocus amount, the locus is estimated, considering the contrast on the waveform as the image pick-up result at the respective defocus amount. That is, the image pick-up result with high contrast at the defocus amount suggests that the S/N ratio of the image pick-up result is high.

Therefore, it is evaluated that the position of the characterized point obtained from the wavelength has high likelihood. On the contrary, the image pick-up result with low contrast at the defocus amount suggests that the S/N ratio of the image pick-up result is low. Then, the locus of the characterized point is estimated, higher the evaluation of the characterized point position, closer the characterized point position.

The position calculating unit 34 estimates that the characterized point position at the focus state is that when the defocus amount is zero, in the locus of the characterized point wherein the obtained defocus amount is a variable.

Then, in step 205, the position calculating unit 34 calculates the position of the mark $MX(i_1, j_1)$ based on the characterized point at the estimated focus state. That is, the respective characterized point at the estimated focus state is corresponding to the respective edge that is the border between the line pattern 83 and the space pattern 84. Therefore, the position calculating unit 34 obtains the X-position of the respective edge based on the estimated respective $X_{MX}$ position, that is, $X_X$ position and the X-positional information (or the velocity information) WPV provided by the wafer interferometer 18, to obtain the average of the edge position, thereby it calculates the X-position of the mark MX $(i_1, j_1)$. Then the position calculating unit 34 stores the mark $MX(i_1, j_1)$ position into the mark position storing area 43.

Then, in step 206, it is decided whether mark positions are calculated for all of the chosen marks or not. Up to the above-mentionedprocedure, the calculation of the markposition for the sole mark $MX(i_1, j_1)$, i.e., the X-position of the mark $MX(i_1, j_1)$ is completed. Therefore, the decision made in step 205 is negative, the process is moved to step 207.

In step 207, the control unit 39 moves the wafer W to the position so that the wafer is in the image pick-up field of the alignment system AS. The control unit 39 moves the wafer stage WST to convey the wafer W by controlling the wafer driving unit 24 through the stage control system 19.

Hereinafter, in step 206, the estimated X-position of the mark $MX(i_m, j_m)$ (m=2 to M) and the Y-position of the mark MY $(i_n, j_n)$ (n=1 to N) are calculated in the same manner as those in the above-mentioned mark $MX(i_1, j_1)$, until it is decided that the estimated mark positions for all of the chosen marks are calculated and then the calculation is finished. Thus the mark positions for all of the chosen marks are calculated to store them into the mark position storing area 43. Then, when the positive decision is made, the detection of the X-position of the mark $MX(i_m, j_m)$ and Y-position $MY(i_n, j_n)$ is finished, and the process is moved to step 208.

Then, in step 208, the parameter calculating unit 35 reads out the X-position of the mark $MX(i_m, j_m)$ (m=1 to M) and the Y-position of the mark $MY(i_n, j_n)$ (n=1 to N) from the mark position storing area 43, and calculates the parameters (error parameters) for calculating the arrangement coordinate of the shot area SA. These parameters are calculated by using any statistical procedure, for example, EGA (Enhanced Global Alignment), which is disclosed Japanese laid open S61-44429 and its corresponding U.S. Patent No. 4,780,617. These disclosure described in the above are fully incorporated by reference herein. Then, the parameter calculating unit 35 stores the parameters calculated into the parameter storing area 44.

As described above, the calculation of the parameter to obtain the arrangement coordinate of the shot area SA is finished.

After that, the control unit 39 reads out the parameters from the parameter storing area 44. Under the control of control unit 39, the wafer W and the reticle R are synchronously moved in reverse direction along the scanning direction (Y-direction) with the velocity ratio corresponding to the projection ratio. The shot area arrangement obtained from parameter value calculated is used and the illumination area with slit shape on the reticle R (the center of the illumination area is coincident with the optical axis AX) is illuminated with the illumination light IL. According to this, the pattern of the pattern area on the reticle R is transferred onto the shot area on the wafer W in reduced magnification.

As described above, in the present embodiment, the position of the alignment marks MX and MY are precisely detected, because these marks are detected by using the image pick-up results at the plural defocus states wherein the contrast between the line pattern portion and the space pattern portion of the alignment mark MX and MY formed on the wafer W can be secured, even when the contrast is low at the focus state. In the present embodiment, the arrangement coordinate of the shot area SA(i, j) on the wafer W is precisely calculated based on the positions of the alignment marks MX and MY which are precisely obtained respectively. Then the pattern formed on the reticle R is precisely transferred onto the respective shot area SA(i, j).

In the present embodiment, the rotation amount around the direction in which the line patterns and the space patterns are arranged mutually is adjusted against the image pick-up plane on which the images of the alignment marks MX and MY are formed. The direction is $X_X$-axis direction for the mark MX, and $Y_Y$-axis direction for the mark MY.

Therefore, when the tilt amount of the image pick-up plane against the imaging plane is adjusted depending on the height difference between the line pattern portion and the space pattern portion at the alignment marks MX and MY, the plural defocus. states that are necessary for the precise mark positional detection might be simultaneously generated on the image pick-up plane. Accordingly, the mark position is rapidly and precisely detected in spite of the height difference between the line pattern portion and the space pattern portion.

In the present embodiment, when there are enough height difference and contrast between the line pattern portion and the space pattern portion at the alignment marks MX and MY, the tilt amount of the image pick-up plane against the imaging plane sets to zero, thereby the mark position might be precisely detected.

Alternatively, in the present embodiment, the change of the characterized point position depending on the change of the defocus amount is estimated from the position of characterized point of the signal waveform in the image pick-up result of the alignment marks MX and MY at the plural defocus states. Thereby the position of characterized point of the alignment marks MX and MY at the focus state is estimated. Therefore, the position of the alignment marks MX and MY are rapidly and precisely detected.

In the present embodiment, the alignment marks MX and MY are detected, reasonably evaluating the likelihood of the characterized point position in the respective state mentioned below based on the both contrast at the respective image pick-up result for the plural defocus state and at the image pick-up result for the focus state. Therefore, the alignment marks MX and My are rapidly and precisely detected.

From the above description, the illumination system, the position detecting apparatus, and other various parts and devices are connected and assembled mechanically, optically and electrically, thereby the exposure apparatus 100 in the present embodiment is produced. The exposure apparatus 100 is preferably produced in the clean room in which the temperature and the cleanliness are controlled.

In the present embodiment, the following structure is employed that the image pick-up plane having the tilt against the imaging plane is intersecting the imaging plane to include the plus defocus state to minus defocus state in the imaging plane. Then, the characterized point position of the alignment marks MX and MY at the focus state is estimated by using the interpolation method. However, the structure in which either the plus defocus state or minus one is generated on the imaging plane might be employed, and the characterized point position of the alignment marks MX and MY at the focus state might be estimated by using the extrapolation method.

In the above-mentioned embodiment, the plural defocus states are generating by rotating the image pick-up plane. However, the plural defocus states might be generating on the image pick-up plane by inserting the wedge-shaped optical glass into the light path.

In the present embodiment, when the characterized point is set to the peak point of the signal waveform that is focused on, the characterized point position at the focus state is estimated. However, the characterized point is decided as the zero point of the signal waveform focused on, and the characterized point position might be estimated by using the interpolation method represented as the dotted line on Fig. 10.

Also in the present embodiment, the image of the alignment marks MX and MY at the plural defocus states are simultaneously picked-up by using the imaging optical system, tilting the imaging plane to the image pick-up plane of the alignment marks MX and MY. However, the image pick-up plane 62X is set in parallel with the imaging plane, and the moving mechanism 65 moves the image pick-up plane 62X in the optical axis direction of the imaging optical system 64X, based on the movement control data DCX, which is transmitted from the main control system 20 and is corresponding to the above-mentioned tilt data RCX. Thereby, the imaging plane is moved to the image pick-up plane 62X along the optical axis direction of the imaging optical system 64X or vise versa. The movement is referred to as "relative movement". In this case, the plural defocus states, those of which are proper for precisely detecting the mark position, might be sequentially generated on the image pick-up plane 62X. On the movement of the relative movement, the wafer W might be moved along the optical axis of the imaging optical system 64X, or the positions of the parts used in the imaging optical system 64X might be adjusted.

The other structure might be employed: wherein the respective light beams through out from the imaging optical system 64X and 64Y are further split into two, and one of the image pick-up plane corresponding to the imaging plane of the split light beam is arranged, and then the other image pick-up plane having the tilt to the imaging plane of the other light beam is arranged. When the enough contrast is generated from the height difference between the marks MX and MY, one of the image pick-up plane might be used. When the height difference is low, the other image pick-up plane might be used.

In the above-mentioned embodiment, the line and space mark, which is the first-dimensional mark, is used as the alignment mark. However, the other first-dimensional mark having different shape or the second-dimensional mark such as box in box mark might be employed to detect the mark position precisely.

The above-mentioned embodiment is explained by using the scanning type exposure apparatus. However, the present invention may apply on any type of the wafer exposure apparatus or liquid crystal exposure apparatus or the like, for example, the reduced projection exposure apparatus of which light source is ultraviolet and soft X-ray with its wave length about 30 nm, X-ray exposure apparatus of which light source is X-ray with its wave length 1 nm, EB (electronbeam) or ion beam exposure apparatus. Furthermore, the present invention may apply on both step-and-repeat machine and step-and-scan machine.

In the above-mentioned embodiment, the position detection of the position mark formed on the wafer and the positioning of the wafer in exposure apparatus are explained. However, the position detection and positioning in which the present invention is applied might be employed for the position detection of the positioning mark formed on the reticle, or positioning of the reticle. Furthermore, the position detection and positioning are applicable to the apparatus except exposure apparatus, for example, the observation apparatus for the substance by using the microscope or the like, the positioning apparatus for the object in the assembly line, the modification line, or inspection line in the factory.

<Device manufacturing>

An embodiment of a device manufacturing method using the exposure apparatus and method above will be described.

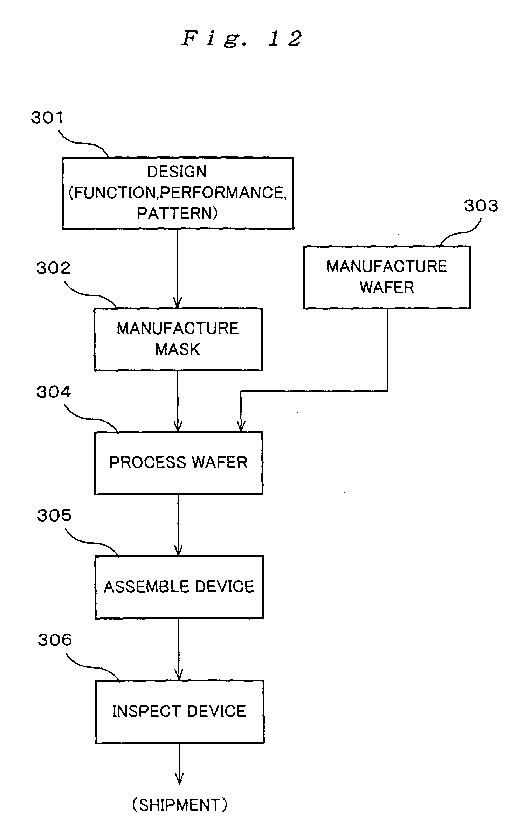

Fig. 12 is a flow chart showing an example of manufacturing a device (a semiconductor chip such as an IC, or LSI, a liquid crystal panel, a CCD, a thin film magnetic head, a micromachine, or the like) . As shown in Fig. 12, in step 301 (design step), function/performance is designed for a device (e.g., circuit design for a semi conductor device) and a pattern to implement the function is designed. In step 302 (mask manufacturing step), a mask on which the designed circuit pattern is formed is manufactured. In step 303 (wafer manufacturing step), a wafer W is manufacturing by using a substance such as silicon.

In step 304 (wafer processing step), an actual circuit and the like are formed on the wafer W by lithography or the like using the mask and wafer prepared in steps 301 to 303, as will be described later. In step 305 (device assembly step), a device is assembled by using the wafer processed in step 304. Step 305 includes process such as dicing, bonding and packaging (chip encapsulation).

Finally, in step 306 (inspection step), a test on the operation of the device, durability test, and the like are performed. After these steps, the device is completed and shipped out.

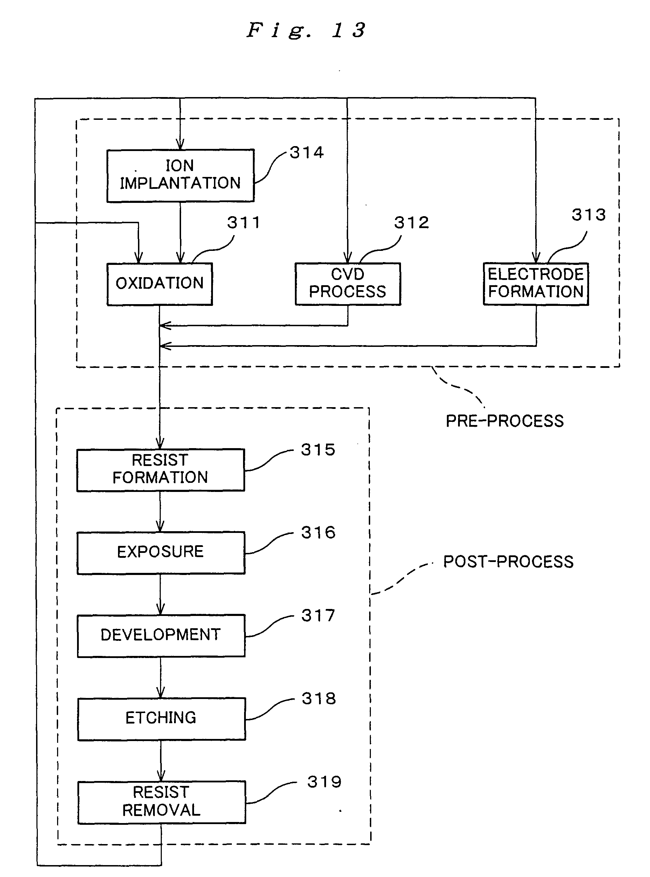

Fig. 13 is a flow chart showing a detailed example of step 304 described above in manufacturing the semiconductor device. Referring to Fig. 13, in step 311 (oxidation step), the surface of the wafer is oxidized. In step 312 (CVD step), an insulating film is formed on the wafer surface. In step 313 (electrode formation step), an electrode is formed on the wafer by vapor deposition. In step 314 (ion implantation step), ions are implanted into the wafer. Steps 311 to 314 described above constitute a pre-process for the respective steps in the wafer process and are selectively executed in accordance with the processing required in the respective steps.

When the above pre-process is completed in the respective steps in the wafer process, a post-process is executed as follows. In this post-process, first, in step 315 (resist formation step), the wafer is coated with a photosensitive agent. Next as, in step 316, the circuit pattern on the mask is transcribed onto the wafer by the above exposure apparatus and method. Then, in step 317 (developing step), the exposed wafer is developed. In step 318 (etching step), and exposed member on a portion other than a portion where the resist is left is removedbyetching. Finally, instep 319 (resist removing step), the unnecessary resist after the etching is removed.

By repeatedly performing these pre-process and post-process, multiple circuit patterns are formed on the wafer.

As described above, the device on which the fine patterns are precisely formed is manufactured.

While the above-described embodiments of the present invention are the presently preferred embodiments thereof, those skilled in the art of lithography system will readily recognize that numerous additions, modifications and substitutions may be made to the above-described embodiments without departing from the spirit and scope thereof. It is intended that all such modifications, additions and substitutions fall within the scope of the present invention, which is best defined by the claims appended below.

**Claims**

1. A position detecting method for detecting positional information of a mark formed on a substance, comprising the steps of:

   picking-up at least one image of said mark under an image pick-up condition including a plurality of defocus states;
   obtaining a relationship between picked-up image state of said mark and said defocus amount, based on image pick-up results in said image pick-up condition; and
   detecting said positional information of said mark based on said relationship.

2. A method according to Claim 1, wherein in said image picking-up step, said image of said mark is picked-up on an image pick-up plane which tilts against an imaging plane on which said image of said mark is formed.

3. A method according to Claim 1 or 2, wherein in said relationship obtaining step, positional information of a characterized point at a focus state is estimated by using said image picked-up results at said plurality of defocus states.

4. A method according to Claim 3, wherein in said relationship obtaining step, the positional information of the characterized point at a focus state is estimated, considering respective contrast of image pick-up results at said plurality of defocus states.

5. A method according to Claim 3 or 4, wherein said defocus states include either plus defocus states or minus defocus states, and a position of said characterized point at said focus state is estimated by an extrapolation method using positions of said characterized point obtained from said image pick-up results at said defocus states.

6. A method according to Claim 3 or 4, wherein a plurality of said defocus states include a plus defocus state and a minus defocus state, and a position of said characterized point at said focus state is estimated by an interpolation method using positions of said characterized point obtained from said image pick-up results at said defocus states.

7. A method according to Claim 1 or 2, wherein said image pick-up condition further comprises a focus state, and said relationship obtaining step comprises the steps of:

estimating positional information of a characterized point at said focus state using said picked-up image at said plurality of defocus states; and further

estimating said positional information of said characterized point at said focus state using said picked-up image at said focus state.

8. A method according to Claim 7, wherein in said positional information detecting step, said positional information is estimated, considering a respective contrast of image pick-up results at said plurality of defocus states and said focus state.

9. A method according to Claim 7 or 8, wherein said defocus states include either plus defocus states or minus defocus states, and

a position of said characterized point at said focus state is estimated by an extrapolation method using positions of said characterized point obtained from results at said defocus states.

10. A method according to Claim 7 or 8, wherein said defocus states include a plus defocus state and a minus defocus state, and

a position of said characterized point mark at said focus state is estimated by an interpolation method using positions of said characterized point obtained from said image pick-up results at said defocus states.

11. Position detecting apparatus for detecting positional information of a mark formed on a substance, comprising:

an image optical system for forming an image of the mark;
an image pick-up means for picking-up the image of the mark formed by the imaging optical system; and
processing means for obtaining the relationship between the picked-up image state of the mark and a defocus amount based on the image pick-up results, the processing means being arranged to use the image pick-up under an image pickup condition including a plurality of defocus states.

12. Apparatus according to Claim 11, wherein with a surface condition of said mark changing along a predetermined direction,

said image pick-up means includes an image pick-up plane which is rotated around a direction in an imaging plane on which said image is formed by said imaging optical system corresponding to said predetermined direction.

13. Apparatus according to Claim 12, and wherein said image pick-up plane intersects said imaging plane.

14. Apparatus according to Claim 11, 12 or 13, further comprising:

tilt adjustment means for adjusting rotation amount of an image pick-up plane of said image pick-up means around a direction in an imaging plane on which said image is formed by said imaging optical system corresponding to said predetermined direction.

15. Apparatus according to Claim 11, 12 or 13, further comprising:

moving means for relatively moving an imaging plane, on which said image of said mark is formed by said imaging optical system, and said image pick-up plane of said image pick-up means along an optical axis direction of the imaging optical system.

16. An exposure method for transferring a predetermined pattern to a divided area on a substrate, comprising the steps of:

detecting positional information in accordance with a method according to any one of Claims 1 to 10, and obtaining a predetermined number of parameter for a position calculation of said divided area, and calculating arrangement information of the divided area on the substrate; and
transferring the pattern to the divided area while controlling a position of said substrate, based on the arrangement information of said divided area.

17. Exposure apparatus for transferring a predetermined pattern to a divided area on a substrate, comprising:

stage means for moving said substrate along a moving plane; and
position detecting apparatus according to any one of Claims 11 to 15, for detecting positional information of said marks on the substrate mounted on the stage means.

**18.** A method of forming an exposure apparatus for transferring a predetermined pattern to a divided area on a substrate, comprising the steps of:

providing stage means for moving the substrate along a moving plane; and
providing position detecting means for detecting a positional information of a mark on said substrate mounted on the stage means, wherein the position detecting means comprises:

an imaging optical system for forming an image of the mark formed on the substrate;
an image pick-up means for picking-up an image formed by said imaging optical system; and
processing means for obtaining a relationship between picked-up image state of the respective mark. and defocus amount based image pick-up results by using the image pick-up means under an image pick-up condition including a plurality of defocus states, and for detecting positional information of the marks based on the relationship.

**19.** A computer readable medium having a program recorded thereon and to be executed by position detecting means, so as to control the position detecting means:

to pick-up at least one image of said mark under an image pick-up condition including a plurality of defocus states;
to obtain a relationship between the picked-up image state of said mark and defocus amount; and
to detect positional information of said mark, based on the said relationship, and so detect a mark position formed on a substrate.

**20.** A device manufacturing method including a lithographic process and wherein an exposure is performed by using the method according to Claim 18 in said lithographic process.

EP 1 122 612 A2

*Fig. 1*

*Fig. 2A*

*Fig. 2B*

*Fig. 2C*

*F i g . 3 A*

*F i g . 3 B*

*Fig. 4A*

*Fig. 4B*

*Fig. 4C*

*Fig. 4D*

Fig. 5A

89
89a     89a                    MX
                               83  84

81

Fig. 5B

90
81a

Fig. 5C

89                             MX
                                    81a

Fig. 5D

89                             MX    PR
                                          93
                                          81

Fig. 5E

89                             MX    PR
                                          93

*Fig. 6*

*F i g. 7*

```
                    ┌──────────┐
                    │  START   │
                    └────┬─────┘
                         ↓
        ┌────────────────────────────┐
        │  MOVE WAFER TO SET 1ST     │──── 201
        │  MARK TO IMAGE PICK-UP     │
        │  POSITION                  │
        └────────────┬───────────────┘
                     ↓ ←─────────────────────────────┐
        ┌────────────────────────────┐               │
        │  PICK-UP IMAGE OF MARK     │──── 202       │
        └────────────┬───────────────┘               │
                     ↓                                │
        ┌────────────────────────────┐               │
        │  EXTRACT CHARACTERIZED     │──── 203       │
        │  POINT POSITION            │               │
        │  AT RESPECTIVE             │               │
        │  DEFOCUS STATE             │               │
        └────────────┬───────────────┘               │
                     ↓                                │
        ┌────────────────────────────┐       ┌───────────────────────┐
        │  ESTIMATE CHARACTERIZED    │── 204  │  MOVE WAFER TO SET    │── 207
        │  POINT POSITION AT         │        │  NEXT MARK TO IMAGE   │
        │  FOCUS STATE FROM THOSE    │        │  PICK-UP POSITION     │
        │  AT DEFOCUS STATES         │        └───────────┬───────────┘
        └────────────┬───────────────┘                    ↑
                     ↓                                     │
        ┌────────────────────────────┐                    │
        │  DETECT MARK POSITION BY   │── 205              │
        │  USING ESTIMATED           │                    │
        │  CHARACTERIZED POINT       │                    │
        │  AT FOCUS STATE            │                    │
        └────────────┬───────────────┘                    │
                     ↓                     206            │
                  ╱──────────╲      N                     │
                 ╱  ALL OF MARK POSITION ╲────────────────┘
                 ╲  ARE DETECTED?         ╱
                  ╲──────────╱
                     ↓ Y
        ┌────────────────────────────┐
        │  CALCULATE PARAMETER OF    │── 208
        │  ARRANGEMENT COORDINATE    │
        │  IN SHOT AREA              │
        └────────────┬───────────────┘
                     ↓
                ┌──────────┐
                │   END    │
                └──────────┘
```

$$Fig. 8$$

## F i g. 9 A

## F i g. 9 B

*Fig. 10*

Fig. 11

*Fig. 12*

301
DESIGN
(FUNCTION,PERFORMANCE,
PATTERN)

303
MANUFACTURE
WAFER

302
MANUFACTURE
MASK

304
PROCESS WAFER

305
ASSEMBLE DEVICE

306
INSPECT DEVICE

(SHIPMENT)

*Fig. 13*

PRE-PROCESS

ION IMPLANTATION — 314

OXIDATION — 311

CVD PROCESS — 312

ELECTRODE FORMATION — 313

POST-PROCESS

RESIST FORMATION — 315

EXPOSURE — 316

DEVELOPMENT — 317

ETCHING — 318

RESIST REMOVAL — 319